# EUROPEAN PATENT APPLICATION

(11) **EP 4 456 331 A1**
(43) Date of publication of application: **30.10.2024**
(21) Application number: 22910555.6
(22) Date of filing: 21.10.2022
(51) Int. Cl.: H01Q 23/00, C01B 32/184, H01L 21/338, H01L 29/778, H01L 29/812, H01P 11/00, H01Q 1/38

(54) **ANTENNA MODULE AND MANUFACTURING METHOD THEREOF**

(30) Priority: 21.12.2021 JP 2021207486
(71) Applicant: Tohoku University, Sendai-shi, Miyagi 980-8577 (JP); National Institute of Information and Communications Technology, Koganei-shi, Tokyo 184-8795 (JP); SHIN-ETSU CHEMICAL CO., LTD., Tokyo 1000005 (JP)
(72) Inventor: FUKIDOME Hirokazu, Sendai-shi, Miyagi 980-8577 (JP); SUEMITSU Tetsuya, Sendai-shi, Miyagi 980-8577 (JP); WATANABE Issei, Koganei-shi, Tokyo 184-8795 (JP); KAWAHARA Minoru, Tokyo 100-0005 (JP); AKIYAMA Shoji, Annaka-shi, Gunma 379-0195 (JP); TOBISAKA Yuji, Annaka-shi, Gunma 379-0195 (JP); KAWAI Makoto, Annaka-shi, Gunma 379-0195 (JP)
(74) Representative: Vossius & Partner Patentanwälte Rechtsanwälte mbB
(86) International application number: PCT/JP2022/039252
(87) International publication number: WO 2023/119833

(57) **Abstract**

An antenna module suitable for use in signal frequency bands from several 10 GHz to 100 GHz and above is provided.

The antenna module comprises: a substrate with at least the top surface being a single crystal of silicon carbide; a single-crystal graphene layer provided in contact with the top surface of the substrate; and a gallium nitride layer on the substrate. The antenna module is characterized in that an antenna element portion is formed by patterning a region in the graphene layer that is not covered by the gallium nitride layer, an active element portion is formed in the gallium nitride layer, and a connection portion connecting the antenna element portion and the active element portion are integrally formed.

## Description

### TECHNICAL FIELD

The present invention relates to an antenna module using graphene as antenna elements and/or wiring and integrally formed with active elements such as amplifiers.

### BACKGROUND ART

In order to realize next-generation mobile communication systems (so-called 6G and Beyond 5G), high-performance antennas suitable for transmitting and receiving at high frequencies such as 100 GHz and above are required. As a candidate for such an antenna, an antenna using graphene as an antenna element has been proposed, which has superior properties (high electrical conductivity, high carrier mobility, and high thermal conductivity) compared to copper, ITO (indium tin oxide), and other materials conventionally used as conductors in antenna elements (see, for example, Patent Document 1).

In the microwave band antenna described in Patent Document 1, a graphene film formed by the CVD method on a copper foil is transferred to a substrate, an Au film is provided on the transferred graphene film as appropriate, and the antenna element is formed by patterning with photolithography, etching, UV-ozone treatment, etc. In this way, an antenna element of the desired shape can be fabricated on the substrate.

### PRIOR ART DOCUMENTS

### PATENT DOCUMENTS

Patent Document 1: JP2019-75626A

### SUMMARY OF THE INVENTION

### PROBLEMS TO BE SOLVED BY THE INVENTION

The antenna used in mobile communication systems, by the way, is used together with an amplifier that amplifies the signal transmitted or received by the antenna element. In the signal frequency band from several 10 GHz to above 100 GHz, the transmission distance between the amplifier and the antenna element should be extremely short (e.g., less than 100 µm).

However, Patent Document 1 only shows the feasibility of the antenna element as a stand-alone device, and there is no specific teaching on its application to a device combined with the amplifier and other devices.

The present invention was made in view of the above and is intended to provide an antenna module suitable for use in signal frequency bands from several 10 GHz to 100 GHz and above.

### MEANS FOR SOLVING THE PROBLEMS

An antenna module, according to an embodiment of the present invention, comprises a substrate with at least the top surface being a single crystal of silicon carbide; a single-crystal graphene layer provided in contact with the top surface of the substrate; and a gallium nitride layer on the substrate. The antenna module is characterized in that an antenna element portion is formed by patterning a region in the graphene layer that is not covered by the gallium nitride layer, an active element portion is formed in the gallium nitride layer, and a connection portion connecting the antenna element portion and the active element portion are integrally formed.

In the present invention, the gallium nitride layer may be provided to cover a part of the graphene layer.

In the present invention, the substrate may be a hybrid substrate with a single crystal layer of silicon carbide fabricated on an insulator base substrate.

In the present invention, the gallium nitride layer may be a layer epitaxially grown on the graphene layer as a buffer layer.

In the present invention, the active element portion may include an amplifier using a HEMT (High Electron Mobility Transistor) formed in the gallium nitride layer.

In the present invention, the connection portion may connect the antenna element portion and the active element portion with a length of less than 100 µm.

The method of manufacturing an antenna module, according to an embodiment of the present invention, comprises: a step of preparing a substrate of which at least the top surface is a single crystal of silicon carbide; a step of forming a graphene layer on the top surface of the substrate; a step of epitaxially growing a gallium nitride layer using the graphene layer as a buffer layer; a step of forming an active element portion including an amplifier in the gallium nitride layer; a step of exposing the graphene layer by removing the area of the gallium nitride layer in which the active element portion is not provided; and a step of forming an antenna element and a connection portion connecting the active element portion with the antenna element by patterning the exposed graphene layer.

The method of manufacturing an antenna module according to another embodiment of the present invention comprises: a step of preparing a substrate of which at least the top surface is a single crystal of silicon carbide; a step of forming a graphene layer on the top surface of the substrate; a step of removing a portion of the graphene layer and forming an antenna element and a connection portion connecting the active element portion with the antenna element by patterning the graphene layer; a step of epitaxially growing a gallium nitride layer in the area where the graphene layer has been removed; and a step of forming an active element portion including an amplifier in the gallium nitride layer;

The method of manufacturing an antenna module, according to further another embodiment of the present invention, comprises: a step of preparing a substrate of which at least the top surface is a single crystal of silicon carbide; a step of forming a graphene layer on the top surface of the substrate; a step of forming an antenna element by patterning the graphene layer; and a step of providing a gallium nitride layer by bonding a gallium nitride device with an active element portion including an amplifier to the graphene layer on the substrate.

In the present invention, in the step of forming the antenna element, an electrode pad and a connection portion connecting the antenna element to the electrode pad may be formed together with the antenna element, and in the step of providing the gallium nitride layer, the gallium nitride device may be bonded to the graphene layer on the substrate so that an electrode on the gallium nitride device and the electrode pad are electrically connected.

In the step of forming the graphene layer in each of the methods of manufacturing an antenna module described above, the graphene layer may be epitaxially grown by sublimating the silicon atoms in a single crystal of silicon carbide on the top surface of the substrate.

In each method of manufacturing an antenna module described above, the substrate may be a hybrid substrate with a single-crystal layer of silicon carbide fabricated on an insulator base substrate.

### EFFECT OF THE INVENTION

According to the antenna module and its manufacturing method, an antenna element using graphene and an active element such as an amplifier are formed integrally, making it possible to realize an antenna module suitable for use in the signal frequency band from several 10 GHz to 100 GHz or higher.

### BRIEF DESCRIPTION OF THE DRAWINGS

Fig. 1 shows a schematic diagram of the structure of the antenna module.
Fig. 2 shows how to connect the electrode to the connection portion.
Fig. 3 shows the first example of the procedure for fabricating an antenna module.
Fig. 4 shows the second example of the procedure for fabricating an antenna module.
Fig. 5 shows a schematic diagram showing a modified example of the structure of the antenna module.

### EMBODIMENTS OF THE INVENTION

Hereinafter, embodiments of the present invention will be described. Common components in each drawing, including the drawings used to explain the background technology, are indicated by the same reference sign.

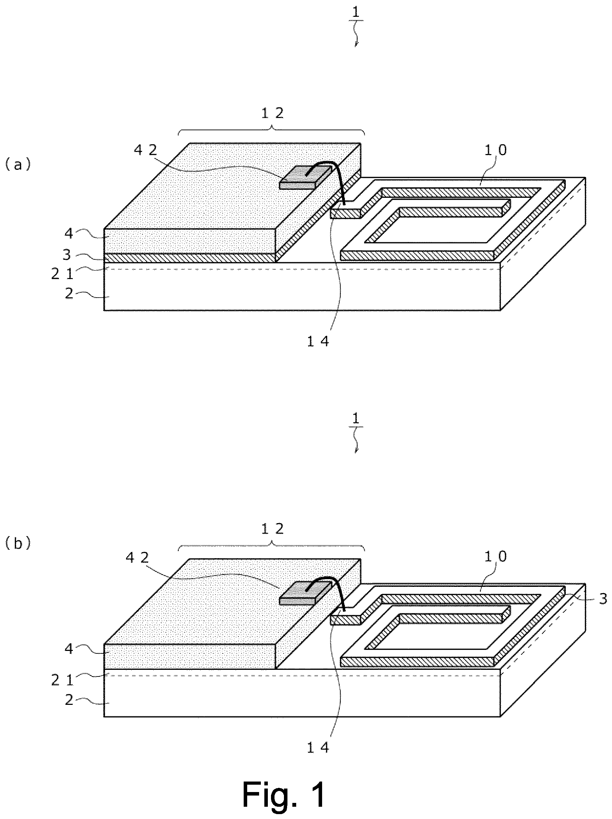

Fig. 1 is a schematic diagram of the structure of an antenna module 1 according to the embodiment of the present invention. As shown in Fig. 1, the antenna module 1 has a layer structure consisting of a substrate 2, a graphene layer 3, and a gallium nitride (GaN) layer 4 stacked in this order. The antenna module 1 then utilizes the aforementioned layer structure to realize an antenna element portion 10, an active element portion 12, and a connection portion 14, as shown in Fig. 1.

The substrate 2 is the basis for forming the graphene layer 3. In the substrate 2, at least the top surface 21 in contact with the graphene layer 3 is a single-crystal silicon carbide (SiC). The rest of the substrate 2, except the top surface, may be an insulator different from SiC. That is, the substrate 2 may be a single-crystal substrate of SiC or a hybrid substrate with a single-crystal layer of SiC fabricated on an insulator. The surface of the single-crystal layer of SiC in the substrate 2 may be (0001) surface. The substrate 2 is the basis for epitaxial growth of graphene that forms the graphene layer 3.

The graphene layer 3 is provided in contact with the top surface of the substrate 2. The graphene layer 3 is composed of a single layer or multiple layers of single-crystal graphene. The graphene layer 3 functions as a buffer layer between the substrate 2 and the GaN layer 4. The graphene layer 3 constitutes the antenna element portion 10 and the connection portion 14 by patterning into the desired antenna shape.

The GaN layer 4 is provided on top of the substrate 2. As an example, the GaN layer 4 is overlaid on the graphene layer 3, as shown in Fig. 1(a). As another example, the GaN layer 4 may be provided directly on the substrate 2 without the graphene layer 3, as shown in Fig. 1(b). In the GaN layer 4, amplifiers and other devices that constitute the active element portion 12 are formed using devices capable of high-speed operation, such as HEMTs (High Electron Mobility Transistors).

Although not shown in Fig. 1, a metal film (e.g., Au film) to form an electrode or wiring pattern, a protective film, or the like may be provided over the graphene layer 3 and GaN layer 4 as needed.

In the antenna module 1 with a layer configuration of the substrate 2, the graphene layer 3, and the GaN layer 4, the antenna element portion 10, the active element portion 12, and the connection portion 14 are provided by partitioning regions in the plane of the substrate 2. As shown in Fig. 1, the active element portion 12 is provided in the GaN layer 4. The active element portion 12 may include other active elements in addition to the amplifiers described above. The active element portion 12 may include electrodes 42 to which wiring from the outside (e.g., antenna element portion 10 or connection portion 14) is connected. The electrode 42 may be provided on the surface of the GaN layer 4 facing the substrate 2 or on the surface opposite to the surface facing the substrate 2.

The GaN layer 4 is not provided in the antenna element portion 10. The antenna element portion 10 has a structure in which the graphene layer 3 is patterned into a shape to achieve the desired antenna properties. A metal film such as Au may be overlaid on some or all of the patterned graphene. Graphene has higher values of various properties such as electrical conductivity, carrier mobility, and thermal conductivity than copper (Cu) and other metals and ITO, so it is possible to achieve antenna properties superior to those of Cu and to suppress property degradation even when antenna size is reduced.

The connection portion 14 is the wiring that connects the electrode 42 of the amplifier of the active element portion 12 to the antenna element portion 10. As with the antenna element portion 10, the connection portion 14 may not be provided with the GaN layer 4, or the connection portion 14 may have a GaN layer 4 overlaid on part or all of the connection portion 14. The connection portion 14 may be formed by patterning the graphene layer 3 or by a metal film such as Au. The connection portion 14 may be formed partly by a metal film and partly by graphene in other parts, or there may be parts where the metal film is overlaid on the graphene. If the antenna element portion 10 and the connection portion 14 are formed solely of graphene, transparent wiring can be achieved. The connection portion 14 should be formed as short as possible (e.g., so that the transmission distance is preferably less than 100 µm, more preferably less than 30 µm, and even more preferably less than 10 um) so that the signal transmitted between the active element portion 12 and the antenna element portion 10 is not degraded.

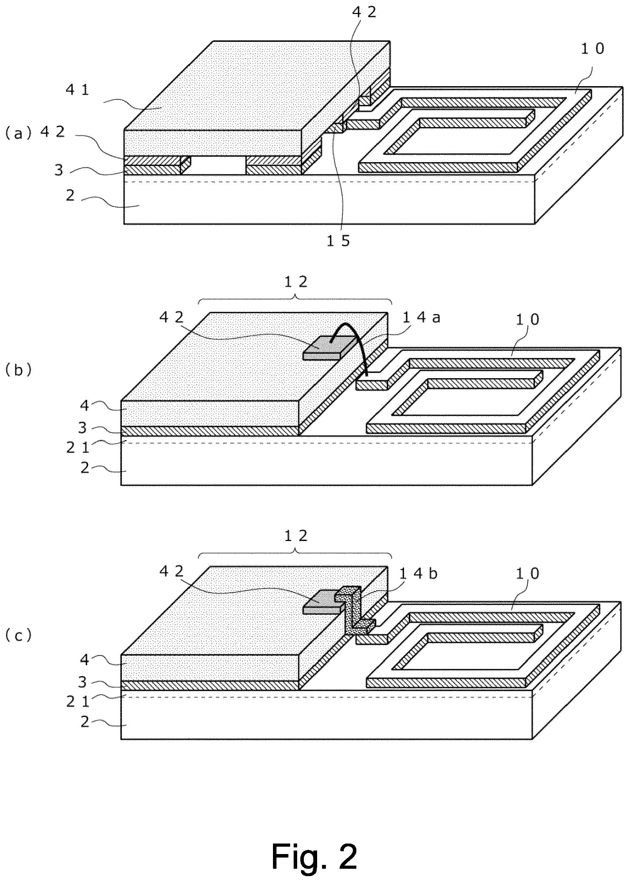

When the electrode 42 is provided on the surface of the GaN layer 4 facing the substrate 2, the electrode 42 and the electrode pad 15 provided at one end of the connection 14 may be connected directly or indirectly with a conductor between them, as shown in Fig. 2(a). When the electrode 42 is provided on the opposite surface of the GaN layer 4 from the surface facing the substrate 2, the electrode 42 may be connected to the connection portion 14a by wire bonding 14a, as shown in Fig. 2(b). Alternatively, as shown in Fig. 2(c), a conductor layer 14b, such as metal, graphene, etc., may be added to connect the electrode 42 to the connection portion 14.

The manufacturing method of the antenna module 1 is then described.

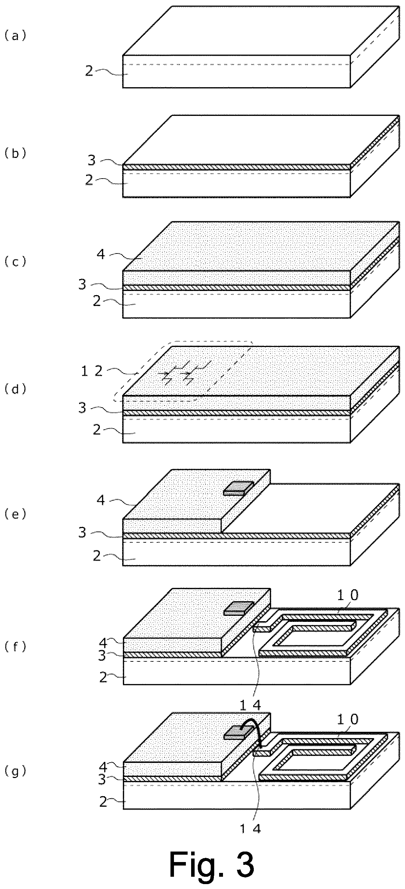

Fig. 3 shows the first example of the procedure for fabricating the antenna module.

As shown in Fig. 3, first the substrate 2 is prepared(Figure 3(a)). At least the top surface in the substrate 2 is a single-crystal SiC, as described above. The crystal structure of this top surface SiC is preferably of 4H-SiC, 6H-SiC, or 3C-SiC.

When a hybrid substrate with a single-crystal layer of SiC on an insulator is used as the substrate 2 instead of the single-crystal substrate of SiC, any of single-crystal silicon, sapphire, polycrystalline silicon, alumina, silicon nitride, aluminum nitride, diamond, or polycrystalline SiC is used as the base substrate, and a film of silicon oxide, single-crystal silicon, polycrystalline silicon, amorphous silicon, alumina, silicon nitride, silicon carbide, aluminum nitride, or diamond is provided on the base substrate as necessary, and the base substrate and silicon carbide substrate are bonded by performing a surface treatment on the bonding surfaces of the base substrate and silicon carbide substrate. Then, a hybrid substrate with a single-crystal layer of SiC thinned by grinding and polishing, ion implantation stripping method etc. can be fabricated. In the ion implantation stripping method, hydrogen or helium ions are implanted into the silicon carbide substrate before peeling, and after bonding, the substrate is peeled off at the ionimplantation interface by heat treatment. After the hybrid substrate is fabricated, CVD is performed on the surface with polycrystalline SiC, and then the base substrate may be removed to obtain the hybrid substrate with the single-crystal layer of SiC on the insulator.

Subsequently, the substrate 2 is preferably heated to 1,100°C or higher to sublimate silicon atoms (Si) near the top surface of the substrate 2 to form a graphene film of the desired thickness (e.g., 50 to 1,500 nm) to form graphene layer 3 (Fig. 3(b)). An example of typical growth conditions for graphene is heating for 5 to 30 minutes in an argon (Ar) atmosphere at an atmospheric pressure of 10⁵ Pa (1 bar) and a temperature of 1500 to 1600°C. When Si is sublimated, a nanocarbon film of either fullerene, graphene, or carbon nanotube is formed, but the preparation conditions should be adjusted appropriately to obtain graphene. The graphene layer 3 formed in this way grows so-called epitaxially so that the crystal is oriented in a predetermined direction relative to the crystal plane of the top SiC single crystal of the base substrate 2.

Then, gallium nitride (GaN) is epitaxially grown using the graphene layer 3 as a buffer layer (i.e., a nucleation layer (template layer) for GaN epi-crystals) to form the GaN layer 4 (Fig. 3(c)). GaN may be epitaxially grown by, for example, metal organic chemical vapor deposition (MOCVD) method. Specifically, trimethylgallium (TMGa), trimethylaluminum (TMAl), and ammonia (NH₃) may be used as precursors for Ga, Al, and N, respectively, and H₂ and N₂ may be used as carrier gases. Prior to film deposition, the substrate 2 with graphene layer 3 may be thermally cleaned at 1100°C for about 5 minutes in an H₂ atmosphere. An AlN buffer layer of several 10 to several 100 nm may be grown on the substrate surface after cleaning, followed by the growth of an undoped GaN layer 4 about 2 um thick at 1050°C. The AlN buffer layer may be grown so that a high-temperature AlN buffer layer grown at about 1080°C is stacked on top of a low-temperature AlN buffer layer grown at about 780°C. In the above example, the graphene layer 3 is used as a nucleation layer (template layer) for GaN epi-crystals. However, before growing GaN epi-crystals, the graphene layer 3 may be removed for the area where GaN is to be grown (that is, the area where the active element portion is to be provided) so that GaN is directly grown on the SiC single crystal of the top surface 21 of substrate 2.

Then, active elements such as HEMTs, passive elements such as resistors, capacitors, inductors, wiring, and electrodes 42, etc. are formed in the grown GaN layer 4 to form active element portion 12 including amplifiers, etc. (Fig. 3(d)).

Then, the GaN layer 4 is removed from the areas other than the active element portion 12 by etching to expose the graphene layer 3 (Fig. 3(e)). In addition, the antenna element portion 10 and the connection portion 14 are patterned on the graphene layer 3 (Fig. 3(f)). This patterning can be performed, for example, by depositing an Au film on the graphene layer 3, patterning the Au film using photolithography and etching techniques, removing the exposed graphene not covered by the Au film by UV-ozone treatment, etc., and then removing the unnecessary parts of the Au film.

Finally, electrically connect the electrode 42 of the active element portion 12 to the connection portion 14 (Fig. 3(g)). The electrode 42 may be connected to the connection portion 14 by wire bonding (Fig. 2(b)) or by adding graphene or a thin metal film (Fig. 2(c)).

Using the above procedure, a monolithic antenna module can be fabricated in which the antenna element portion 10 and the active element portion 12 are provided on the substrate 2, and the two are connected by the connection portion 14. The formation of the active element part 12 and the formation of the antenna element part 10 and the connection part 14 may be performed in different orders, or some or all of the processes may be performed simultaneously.

The antenna module 1 fabricated as described above has the antenna element portion 10 and the active element portion 12 in close proximity, and the two are connected by a very short connection portion 14, thereby suppressing degradation of the signal propagating between the antenna element portion 10 and the active element portion 12 even in the signal frequency band from several 10 GHz to 100 GHz or higher.

In the antenna module 1 fabricated by the above procedure, the graphene layer 3 is a single-crystal film formed by epitaxial growth on the SiC single-crystal on the top surface of the substrate. This results in superior graphene properties (conductivity, carrier mobility, thermal conductivity, film strength, etc.) compared to the method of transferring a separately fabricated polycrystalline graphene film onto the substrate. Antenna elements made by patterning such single-crystal graphene are expected to have superior characteristics compared to antenna elements made of polycrystalline graphene as well as antenna elements made of thin metal films such as copper, and the characteristics will not deteriorate even if the antenna size is reduced.

In the antenna module 1 fabricated by the above procedure, not only the graphene layer 3 but also the GaN layer 4 is formed by epitaxial growth. Therefore, both the graphene layer 3 and the GaN layer 4 are formed so that the crystals are oriented in respective predetermined directions relative to the crystal plane of the single-crystal SiC on the top surface of the substrate 2. In other words, the graphene layer 3 and the GaN layer 4 are oriented so that their crystals form a relatively predetermined angle. This can suppress the electrical resistance and parasitic resistance between the GaN-HEMT and the graphene antenna, thereby improving the antenna's radiation efficiency and other characteristics.

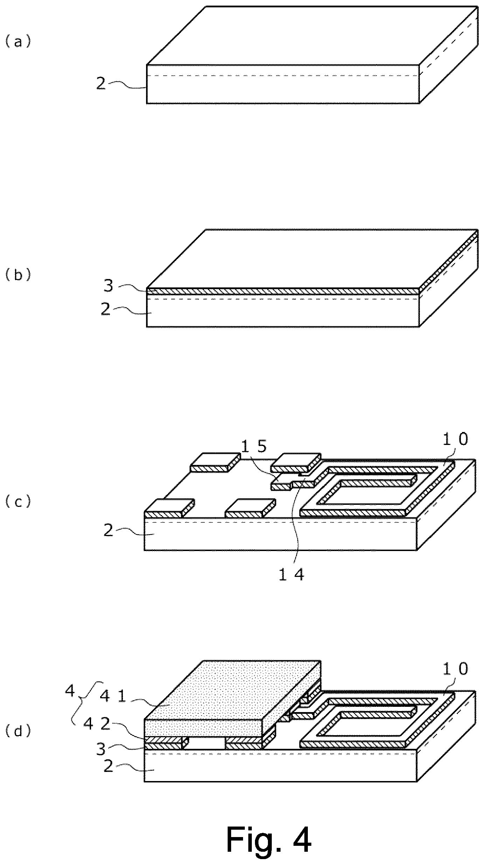

Fig. 4 shows the second example of the procedure for fabricating an antenna module. This procedure differs from the first example described above in that the GaN layer is provided by separately preparing a GaN device 41 without epitaxial growth of the GaN layer 4 and bonding the GaN device 41 to the substrate 2 on which the graphene layer 3 is provided.

In the second example of the procedure to fabricate the antenna module, first, a substrate 2 is prepared (Fig. 4(a)) and a graphene layer 3 is formed on the top surface of the substrate 2 (Fig. 4(b)) using the same method described with reference to Figs. 3(a) and (b) .

Then, the antenna element portion 10 and the connection portion 14 are patterned on the graphene layer 3 (Fig. 4(c)). The electrode pad 15, which is connected to the electrode 42 of the active element portion 12 when GaN device 41 is bonded in the later stage, is also patterned in a manner that extends from the connection portion 14. Other patterns of graphene layer 3 (or Au film on top of it) required for bonding with GaN device 41 may also be formed. In other words, the graphene layer 3 may function as an adhesive layer to bond the active element portion 12 to the substrate 2. The patterning can be done, for example, by depositing an Au film on the graphene layer 3, patterning the Au film using photolithography and etching techniques, removing the exposed graphene not covered by the Au film by UV-ozone treatment, etc., and then removing the unnecessary parts of the Au film In this way, the antenna element portion 10 can be formed monolithically on the substrate 2. The pattern used for bonding with the GaN device 41 may be formed by removing the graphene layer 3 and using only a thin metal film such as Au. The pattern used for bonding to the GaN device 41 may be made of graphene, thin metal films, or stacks of these. The pattern used for bonding to the GaN device 41 may also serve the function of ensuring an electrical connection between the elements in the GaN device 41 and the outside, as well as the electrode pad 15 connected to the electrode 42.

Then, the GaN device 41 separately prepared is bonded to the appropriate position on the substrate 2 (Fig. 4(d)). The GaN device 41 is a GaN substrate on which the amplifiers and other elements that constitute the active element portion 12 are formed and cut into predetermined dimensions. The surface of the GaN device 41 (the surface that is bonded to the substrate 2) is provided with electrodes 42 for exchanging signals with the elements in the active element portion 12. When the GaN device 41 and the substrate 2 are bonded, the electrode 42 of the GaN device 41 is electrically connected to the electrode pad 15 on the substrate 2. The bonding of the GaN device 41 and the substrate 2 may be performed after activation or surface treatment is performed on the surfaces of both. The GaN device 41 can also be bonded to the substrate 2 by flip chip bonding. The GaN device 41 bonded to the substrate 2 serves as the GaN layer 4 in the antenna module 1.

Using the above procedure, an integrated antenna module can be fabricated in which the antenna element portion 10 and the active element portion 12 are provided on the substrate 2, and the two are connected by the connection portion 14.

The antenna module 1 fabricated as described above has the antenna element portion 10 and the active element portion 12 in close proximity, and the two are connected by a very short connection portion 14, thereby suppressing degradation of the signal propagating between the antenna element portion 10 and the active element portion 12 even in the signal frequency band from several 10 GHz to 100 GHz or higher.

In the antenna module 1 fabricated by the above procedure, the graphene layer 3 is a single-crystal film formed by epitaxial growth on the single-crystal SiC on the top surface of the substrate. This results in superior graphene properties (conductivity, carrier mobility, thermal conductivity, film strength, etc.) compared to the method of transferring a separately fabricated polycrystalline graphene film onto the substrate. Antenna elements made by patterning such single-crystal graphene are expected to have superior characteristics compared to antenna elements made of polycrystalline graphene as well as antenna elements made of thin metal films such as copper, and the characteristics will not deteriorate even if the antenna size is reduced.

In the antenna module 1 fabricated by the above procedure, the GaN device 41 with the active element portion 12 can be separately prepared and then bonded to the substrate 2, which provides a high degree of freedom in the design of the active element portion 12. In addition, by preparing multiple types of GaN devices 41 to be bonded with different functions and performances, the antenna module 1 can be made in various variations while keeping the antenna element portion 10 in common.

### [Modification of embodiments]

The present invention is not limited to the above embodiments or examples.

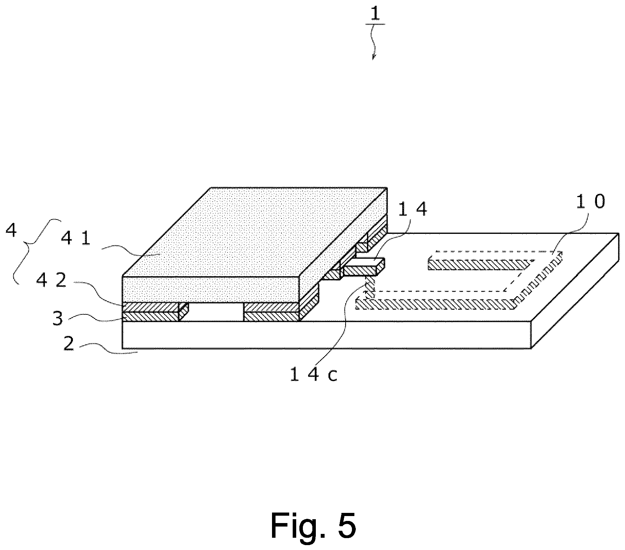

For example, in the above embodiment, the antenna element portion 10 and the active element portion 12 are provided on the same side of the substrate 2. However, as shown in Fig. 5, the antenna element portion 10 may be provided on the opposite side of the substrate 2 from the side where the active element portion 12 is provided. In this case, the connection portion 14 connecting the antenna element portion 10 and the active element portion 12 may include a through-substrate via 14c that passes through the substrate 2 and electrically connects both sides of the substrate. Moreover, in this case, the graphene layer 3 may be provided on both sides of the substrate 2, and the wiring of the connection portion 14 drawn to the active element portion 12, the electrode pad to be bonded to the active element portion 12, and the antenna element portion 10 may be made of graphene.

In the second example of the procedure to fabricate the antenna module in the above embodiment, the electrode 42 was provided on the substrate bonding surface of the active element portion 12, and electrode pad 15 on substrate 2 was directly connected to electrode 42, but electrode 42 may be provided on the opposite side of the GaN layer 4 from the side facing substrate 2. In this case, the electrode pad 15 may not be provided on the substrate, and the electrode 42 may be connected to the connection portion 14 by wire bonding or adding a conductor layer, as shown in Fig. 2(b).

Any configuration that has substantially the same as the technical concept described in the claims of the present invention and that produces similar effects is included in the technical scope of the present invention, no matter what modifications have been made.

### REFERENCE SIGNS LIST

1 Antenna module
2 Substrate
3 Graphene layer
4 GaN layer
10 Antenna element portion
12 Active element portion
14 Connection portion
15 Electrode pad
41 GaN Device
42 Electrode

## Claims

1. An antenna module comprising:
a substrate with at least the top surface being a single crystal of silicon carbide;
a single-crystal graphene layer provided in contact with the top surface of the substrate; and
a gallium nitride layer on the substrate,
wherein an antenna element portion is formed by patterning a region in the graphene layer that is not covered by the gallium nitride layer, an active element portion is formed in the gallium nitride layer, and a connection portion connecting the antenna element portion and the active element portion are integrally formed.

2. The antenna module according to claim 1, wherein the gallium nitride layer is provided to cover part of the graphene layer.

3. The antenna module according to claim 1 or 2, wherein the substrate is a hybrid substrate with a single-crystal layer of silicon carbide fabricated on an insulator base substrate.

4. The antenna module according to any one of claims 1 to 3, wherein the gallium nitride layer is a layer epitaxially grown on the graphene layer as a buffer layer.

5. The antenna module according to any one of claims 1 to 4, wherein the active element portion includes an amplifier using a HEMT (High Electron Mobility Transistor) formed in the gallium nitride layer.

6. The antenna module according to any one of claims 1 to 5, wherein the connection portion connects the antenna element portion and the active element portion with a length of less than 100 µm.

7. A method of manufacturing an antenna module comprising:
a step of preparing a substrate of which at least the top surface is a single crystal of silicon carbide;
a step of forming a graphene layer on the top surface of the substrate;
a step of epitaxially growing a gallium nitride layer using the graphene layer as a buffer layer;
a step of forming an active element portion including an amplifier in the gallium nitride layer;
a step of exposing the graphene layer by removing the area of the gallium nitride layer in which the active element portion is not provided; and
a step of forming an antenna element and a connection portion connecting the active element portion with the antenna element by patterning the exposed graphene layer.

8. A method of manufacturing an antenna module comprising:
a step of preparing a substrate of which at least the top surface is a single crystal of silicon carbide;
a step of forming a graphene layer on the top surface of the substrate;
a step of removing a portion of the graphene layer and forming an antenna element and a connection portion connecting the active element portion with the antenna element by patterning the graphene layer;
a step of epitaxially growing a gallium nitride layer in the area where the graphene layer has been removed; and
a step of forming an active element portion including an amplifier in the gallium nitride layer.

9. A method of manufacturing an antenna module comprising:
a step of preparing a substrate of which at least the top surface is a single crystal of silicon carbide;
a step of forming a graphene layer on the top surface of the substrate;
a step of forming an antenna element by patterning the graphene layer; and
a step of providing a gallium nitride layer by bonding a gallium nitride device with an active element portion including an amplifier to the graphene layer on the substrate.

10. The method of manufacturing an antenna module according to claim 9, wherein,
in the step of forming the antenna element, an electrode pad and a connection portion connecting the antenna element to the electrode pad are formed together with the antenna element, and
in the step of providing the gallium nitride layer, the gallium nitride device is bonded to the graphene layer on the substrate so that an electrode on the gallium nitride device and the electrode pad are electrically connected.

11. The method of manufacturing an antenna module according to any one of claims 8 to 10, wherein, in the step of forming the graphene layer, the graphene layer is epitaxially grown by sublimating the silicon atoms in a single crystal of silicon carbide on the top surface of the substrate.

12. The method of manufacturing an antenna module according to any one of claims 8 to 11, wherein the substrate is a hybrid substrate with a single-crystal layer of silicon carbide fabricated on an insulator base substrate.
